# FASCICULE DE BREVET EUROPEEN

(11) **EP 2 899 821 B1**
(45) Date de publication et mention de la délivrance du brevet: **02.03.2022**
(21) Numéro de dépôt: 14184411.8
(22) Date de dépôt: 11.09.2014
(51) Int. Cl.: H02H 1/00, G01R 31/52, H02H 3/10, H02H 3/347, H02H 3/04, H02H 1/06, H02H 3/00

(54) **Dispositif de contrôle et de protection électrique**
Steuervorrichtung und elektrisches Schutzgerät
Control device and electric protection device

(30) Priorité: 12.09.2013 FR 1358774
(43) Date de publication de la demande: 29.07.2015
(73) Titulaire: Schneider Electric Industries SAS, 92500 Rueil-Malmaison (FR)
(72) Inventeur: Belhaja, Zakaria, 38050 Grenoble Cedex 09 (FR); Tian, Simon, 38050 Grenoble Cedex 09 (FR); Zeller, Clément, 38050 Grenoble Cedex 09 (FR)
(74) Mandataire: Lavoix

(56) Documents cités:
- EP-A2- 1 589 628
- US-A1- 2010 254 057
- US-A1- 2010 324 747

## Description

La présente invention concerne le domaine des dispositifs de contrôle et de protection électrique adapté pour être disposé dans une installation électrique comprenant un ensemble de conducteur(s) électrique(s), selon la revendication 1.

La présente invention vise à proposer un, dispositif de contrôle et de protection électrique tirant avantageusement parti des mesures effectuées pour détecter la présence d'arcs électriques, pour fournir une protection accrue de l'installation électrique.

Un tel dispositif de contrôle et de protection électrique mutualise ainsi avantageusement les mesures effectuées pour la détection d'arcs électrique et permet de protéger l'installation électrique contre des dysfonctionnements électriques supplémentaires.

Dans des modes de réalisation, le dispositif de contrôle et de protection électrique suivant l'invention comporte en outre une ou plusieurs des caractéristiques suivantes :
- les moyens de traitement sont en outre adaptés pour générer, en cas de détection dudit dysfonctionnement, un signal de déclenchement et transmettre ledit signal de déclenchement à destination d'un dispositif de commutation électrique adapté pour stopper la circulation du courant électrique dans au moins le conducteur dudit ensemble de conducteurs électriques en réponse à la réception dudit signal de détection ;
- il comprend en outre un dispositif de commutation électrique adapté pour stopper la circulation du courant électrique dans au moins ledit conducteur dudit ensemble de conducteurs électriques en réponse à la réception dudit signal de déclenchement généré par les moyens de traitement ;
- les moyens de traitement sont adaptés pour déterminer la valeur d'un paramètre en fonction au moins de mesures effectuées par lesdits moyens de mesure, et pour détecter un dysfonctionnement en fonction de la comparaison entre un seuil de déclenchement et une variable représentative de ladite valeur déterminée ;
   lesdits moyens de traitement étant en outre adaptés pour comparer ladite variable représentative de ladite valeur déterminée et un seuil d'alerte, distinct dudit seuil de déclenchement, et pour générer un signal d'alerte en fonction de ladite comparaison ;
- les moyens de traitement sont adaptés pour, suite à la détection d'un dysfonctionnement, générer et pour transmettre un signal de diagnostic comprenant des informations caractérisant la nature et la source du dysfonctionnement ;
- les moyens de traitement sont adaptés pour, une fois un dysfonctionnement détecté, ne transmettre le signal de déclenchement consécutif à la détection dudit dysfonctionnement, qu'après la transmission du signal de diagnostic ;
- il comprend des moyens principaux de fourniture d'énergie électrique en provenance de l'installation électrique pour alimenter le détecteur d'arc électrique et comprenant des moyens auxiliaires de fourniture d'énergie électrique adaptés en outre pour stocker ladite énergie électrique, lesdits moyens auxiliaires de fourniture d'énergie électrique étant adaptés pour alimenter le module de traitement sélectivement lorsque suite à la transmission d'un signal de déclenchement, l'alimentation électrique des moyens principaux par l'installation est stoppée ;
- les moyens auxiliaires de fourniture d'énergie électrique sont dimensionnés pour alimenter le module de traitement, sélectivement, suite à la transmission d'un signal de déclenchement par le détecteur d'arc électrique, et jusqu'à la transmission du signal de diagnostic ;
- les moyens de traitement sont adaptés pour déterminer l'énergie consommée au point de mesure du dispositif dans un tableau électrique, qui correspond à divers éléments respectifs de consommation d'énergie dans le circuit en aval du dispositif ;
- la détermination, par les moyens de traitement, de l'énergie consommée comprend le calcul de valeurs efficaces de courant et/ou de valeurs efficaces de tension, et/ou de la puissance active ou réactive, et/ou du facteur de puissance et/ou de l'énergie consommée ;
- il comprend un capteur de température, les moyens de traitement étant adaptés pour corriger les mesures de tension ou courant des moyens de mesure en fonction de température(s) mesurée(s) par le capteur de température.

Ces caractéristiques et avantages de l'invention apparaîtront à la lecture de la description qui va suivre, donnée uniquement à titre d'exemple, et faite en référence aux dessins annexés, sur lesquels :
- la figure 1 représente une installation électrique dans laquelle est installé un dispositif de contrôle et de protection électrique dans un mode de réalisation de l'invention ;
- la figure 2 est une vue de sous-modules fonctionnels d'un module de traitement d'un dispositif de contrôle et de protection électrique dans un mode de réalisation de l'invention ;
- la figure 3 représente un dispositif de contrôle et de protection électrique dans un mode de réalisation de l'invention ;
- la figure 4 représente un dispositif de contrôle et de protection électrique dans un mode de réalisation de l'invention ;
- la figure 5 représente un dispositif de contrôle et de protection électrique dans un mode de réalisation de l'invention ;
- la figure 6 représente un dispositif de contrôle et de protection électrique dans un mode de réalisation de l'invention.

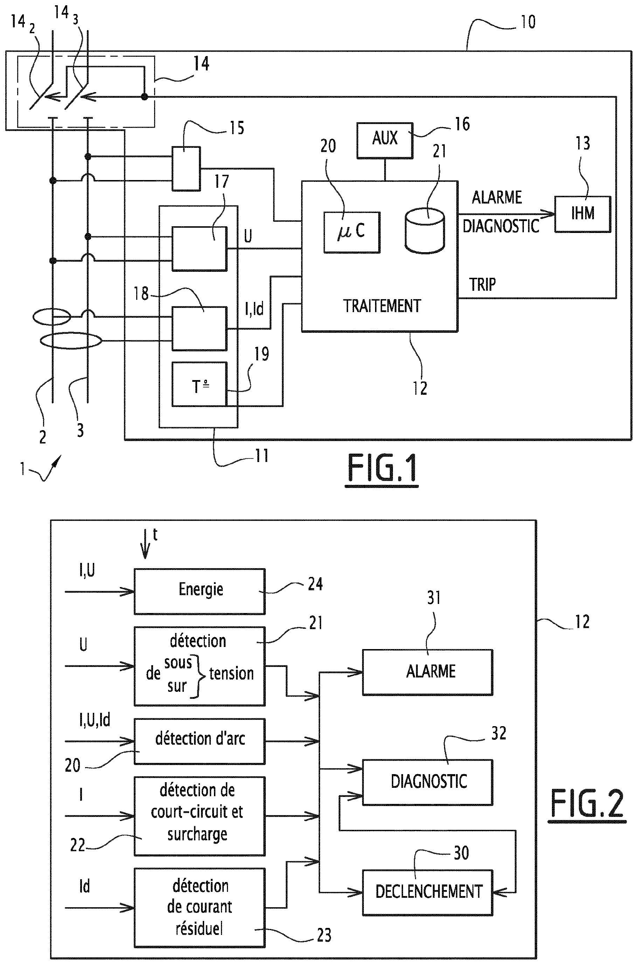

Sur la figure 1, une portion d'une installation électrique 1, par exemple résidentielle ou tertiaire, est représentée. Elle comporte deux câbles conducteurs de courant, par exemple un conducteur de phase 2 et un conducteur de neutre 3.

Un dispositif de contrôle et de protection électrique 10 est connecté à l'installation électrique 1, par exemple au sein d'un tableau électrique. Le dispositif de contrôle et de protection électrique 10 comporte un ensemble 11 de mesure, un module de traitement 12, une interface homme-machine 13, un disjoncteur 14, un raccordement 15 à une alimentation électrique principale, et des moyens auxiliaires 16 de fourniture d'alimentation électrique.

L'ensemble de mesure 11 comporte par exemple :
- un capteur de tension 17, adapté pour mesurer périodiquement la valeur courante de la tension U entre le conducteur de phase 2 et le conducteur de neutre 3 ;
- un ensemble de deux capteurs de courant 18, adapté pour mesurer périodiquement la valeur courante du courant I circulant dans le conducteur de phase 2, et en outre pour mesurer le courant résiduel I_{d}, i.e. la différence d'intensité entre le courant dans le conducteur de phase 2 et le courant dans le conducteur de neutre 3.

Les valeurs périodiquement mesurées par les capteurs 17-18 pour la tension, U, le courant de phase I et le courant résiduel I_{d} sont délivrées par l'ensemble de mesure 11 au module de traitement 12.

La fréquence des mesures par les capteurs 17, 18 est par exemple comprise dans la plage [1kHz, 10kHz].

Le module de traitement 12 comprend un microcalculateur 20 et une mémoire 21.

La mémoire 21 comprend notamment des instructions logicielles qui, lorsqu'elles sont exécutées sur le microcalculateur 20, mettent en œuvre les fonctions décrites ci-dessous en référence à la figure 2 et réalisées par le module de traitement 12.

Le module de traitement 12 est en effet adapté pour effectuer un certain nombre de traitements en fonction des valeurs de mesure qui lui sont fournies en entrée.

Le module de traitement 12 est en outre adapté pour générer en fonction de ces traitements des signaux d'alarme ou de diagnostic et les transmettre à destination de l'interface homme-machine 13 et/ou pour générer des signaux de déclenchement et les transmettre à destination du disjoncteur 14.

Suivant les modes de réalisation, l'interface homme-machine 13 peut être intégrée dans le dispositif de contrôle et de protection électrique 10 ou distante du dispositif 10. La liaison entre le dispositif 10 et l'interface homme-machine peut être de type filaire ou radiofréquence. Dans des modes de réalisation, une partie de l'interface homme-machine 13 est intégrée dans le dispositif 10 (par exemple le dispositif 10 comporte un écran d'affichage et des moyens de génération d'une alarme sonore et/ou lumineuse) et une autre partie de l'interface homme-machine 13 est distante (par exemple, cette autre partie comprend une station de travail avec journal d'alarmes et d'événements, et fonctions de maintenance notamment le cas échéant pour piloter à distance l'ouverture ou la fermeture des commutateurs 14₂ et 14₃).

Le disjoncteur 14 comprend deux commutateurs 14₂ et 14₃ et est adapté pour piloter, en fonction des signaux de déclenchement reçus en provenance du module de traitement 12, l'ouverture, et éventuellement la fermeture, des commutateurs 14₂ et 14₃.

Le commutateur 14₂ est disposé sur le conducteur de phase 2 et le commutateur 14₃ est disposé sur le conducteur de neutre 3. Quand le commutateur 14₂ est en position fermée, un courant électrique circule dans le conducteur de phase 2 et quand le commutateur 14₂ est en position ouverte, la circulation du courant électrique dans le conducteur de phase 2 est stoppée.

De façon analogue, quand le commutateur 14₃ est en position fermée, un courant électrique circule dans le conducteur de neutre 3 et quand le commutateur 14₃ est en position ouverte, la circulation du courant électrique dans le conducteur de neutre 3 est stoppée.

Suivant les modes de réalisation, le disjoncteur 14 est intégré dans le dispositif de contrôle et de protection électrique 10, ou distant du dispositif 10. La liaison entre le dispositif 10 et le disjoncteur 14 peut être de type filaire ou radiofréquence.

Le raccordement 15 à l'alimentation électrique 1 est adapté pour alimenter le dispositif de contrôle et de protection électrique 10 à l'aide de la tension U provenant de l'installation électrique 1.

Les moyens auxiliaires 16 de fourniture d'alimentation électrique sont adaptés pour stocker de l'énergie et pour alimenter au moins une partie du dispositif 10 lorsque l'installation électrique 1 ne fournit plus d'alimentation électrique, comme il sera décrit par la suite.

Les fonctions mises en œuvre par des sous-modules du module de traitement 12, en coopération avec les autres modules du détecteur 10, dans un mode de réalisation de l'invention, sont décrites ci-après en référence à la figure 2.

Le module de traitement 12 considéré comporte un sous-module de détection d'arc électrique 20, un sous-module de détection de sous-tension et sur-tension 21, un sous-module de détection de court-circuit et surcharge 22, un sous-module de détection de courant résiduel 23.

Le module de traitement 12 considéré comporte en outre un sous-module de déclenchement 30, un sous-module d'alarme 31 et un sous-module de diagnostic 32.

Le sous-module de détection d'arc électrique 20 est adapté pour traiter les mesures de courant I, de tension U et de courant résiduel I_{d}, régulièrement fournies par les capteurs 17, 18 de manière à déterminer les valeurs d'un (ou plusieurs) paramètre(s) de détection d'arc, en fonction des courant I, tension U et courant résiduel I_{d}.

La méthode de détection d'arc peut être variée, par exemple similaire à celles décrites dans WO 00/08663 ou FR 2 802 721 Le document US 2010324747 divulgue également une méthode de détection d'arc. Ce document décrit en plus comment d'autres paramètres sont détectés et transmit avant que l'arc soit détecté.

Le sous-module de détection de sous-tension et surtension 21 est adapté pour traiter les mesures de tension U régulièrement fournies par le capteur 17 de manière à déterminer les valeurs d'un (ou plusieurs) paramètre(s) de détection de dysfonctionnements en tension, en fonction de cette tension U mesurée.

Ces valeurs de tension traitées peuvent être en valeur efficace, valeur moyenne ou valeur crête, la méthode de calcul étant bien connue par les hommes du métier.

Le sous-module de détection de court-circuit 22 est adapté pour traiter les mesures de courant I régulièrement fournies par le capteur 18 de manière à déterminer les valeurs d'un (ou plusieurs) paramètre(s) de détection de court-circuit et surcharge, en fonction de ce courant I mesuré.

Ces valeurs de courant traitées peuvent être en valeur efficace, valeur moyenne ou valeur crête, la méthode de calcul étant bien connue par les hommes du métier.

Le sous-module de détection de courant résiduel 23 est adapté pour traiter les mesures de courant I_{d} régulièrement fournies par le capteur 18 de manière à déterminer les valeurs d'un (ou plusieurs) paramètre(s) de détection de courant résiduel, en fonction de ce courant I_{d} mesuré.

Ces valeurs de courant traitées peuvent être en valeur efficace, valeur moyenne ou valeur crête, la méthode de calcul étant bien connue par les hommes du métier.

Les valeurs successivement déterminées pour les paramètres de détection d'arc, de sous-tension, de sur-tension, de court-circuit, de surcharge et de courant résiduel sont délivrées par les sous-modules 20-23, au fur et à mesure de leur détermination, au sous-module de déclenchement 30.

Le sous-module de déclenchement 30 est adapté pour déterminer en fonction de la dernière valeur ou des dernières valeurs reçue(s) du paramètre (ou des paramètres) de détection d'arc si la survenue ou la présence d'un arc électrique est très probable ou avérée, par comparaison de cette valeur ou ces valeurs avec une ou des valeurs-seuils de déclenchement correspondant à une détection d'arc.

En fonction du résultat de cette comparaison, un signal de déclenchement « TRIP » de protection est généré par le sous-module de déclenchement 30 et est transmis à destination du disjoncteur 14.

Similairement, dans l'exemple considéré, le sous-module de déclenchement 30 est adapté pour déterminer en fonction de la dernière valeur ou des dernières valeurs reçue(s) du paramètre (ou des paramètres) de détection de dysfonctionnements en tension si la survenue ou la présence d'une sur-tension ou sous-tension est très probable ou avérée, par comparaison de cette valeur ou ces valeurs à une valeur-seuil de déclenchement correspondant à une détection de surtension, respectivement de sous-tension.

En fonction du résultat de cette comparaison, un signal de déclenchement « TRIP » de protection est généré par le sous-module de déclenchement 30 et est transmis à destination du disjoncteur 14.

Dans l'exemple considéré, le sous-module de déclenchement 30 est en outre adapté pour déterminer en fonction de la dernière valeur ou des dernières valeurs reçue(s) du paramètre (ou des paramètres) de détection de court-circuit et surcharge si la survenue ou la présence d'un court-circuit ou d'une surcharge est très probable ou avérée, par comparaison de cette valeur ou ces valeurs avec une ou des valeurs-seuils de déclenchement correspondant à une détection de court-circuit, respectivement à une détection de surcharge.

En fonction du résultat de cette comparaison, un signal de déclenchement « TRIP » de protection est généré par le sous-module de déclenchement 30 et est transmis à destination du disjoncteur 14.

Dans l'exemple considéré, le sous-module de déclenchement 30 est en outre adapté pour déterminer en fonction de la dernière valeur ou des dernières valeurs reçue(s) du paramètre (ou des paramètres) de détection de courant résiduel si la survenue ou la présence d'un courant résiduel est très probable ou avérée, par comparaison de cette valeur ou ces valeurs avec une ou des valeurs-seuils de déclenchement correspondant à une détection de courant résiduel.

En fonction du résultat de cette comparaison, un signal de déclenchement « TRIP » de protection est généré par le sous-module de déclenchement 30 et est transmis à destination du disjoncteur 14.

Suite à la réception d'un signal de déclenchement « TRIP » par le sous-module de déclenchement 30, le disjoncteur 14 est adapté pour ouvrir les commutateurs 14₂ et 14₃ de manière à stopper la circulation du courant électrique sur les conducteurs de phase 2 et neutre 3.

Une telle coupure arrête l'alimentation du circuit en aval du disjoncteur, assure ainsi la protection contre la cause du défaut détecté (défaut d'arc, court-circuit, surcharge, surtension, ...).

Une telle coupure provoque aussi l'arrêt de l'alimentation électrique du dispositif de contrôle et de protection électrique 10 par le raccordement 15 à l'alimentation électrique 1.

Afin de réduire ces ruptures de service brutales, dans un mode de réalisation, le module de traitement 12 est adapté pour prendre en compte en outre des seuils d'alarme, outre les seuils de déclenchement. Une valeur-seuil d'alarme pour un dysfonctionnement donné est distincte de la valeur-seuil de déclenchement pour ce dysfonctionnement et est située entre la valeur-seuil de déclenchement et des valeurs correspondant à un fonctionnement opérationnel.

Dans un tel mode de réalisation, les valeurs successivement déterminées pour les paramètres de détection d'arc, de sous-tension, de sur-tension, de court-circuit, de surcharge et de courant résiduel sont délivrées par les sous-modules 20-23, au fur et à mesure de leur détermination, au sous-module d'alarme 31.

Le sous-module d'alarme 31 est adapté pour déterminer, en fonction de la dernière valeur ou des dernières valeurs reçue(s) du paramètre (ou des paramètres) de détection d'arc, si l'état de l'installation électrique est propice à la survenue d'un arc électrique, par comparaison de cette valeur ou ces valeurs avec une ou des valeurs-seuils d'alarme correspondant à une détection d'arc.

Similairement, dans l'exemple considéré, le sous-module d'alarme 31 est adapté pour déterminer, en fonction de la dernière valeur ou des dernières valeurs reçue(s) du paramètre (ou des paramètres) de détection de dysfonctionnements en tension, si l'état de l'installation électrique est propice à la survenue d'une sur-tension ou sous-tension, par comparaison de cette valeur ou ces valeurs à une valeur-seuil d'alarme correspondant à une détection de sur-tension, respectivement de sous-tension.

Dans l'exemple considéré, le sous-module d'alarme 31 est en outre adapté pour déterminer, en fonction de la dernière valeur ou des dernières valeurs reçue(s) du paramètre (ou des paramètres) de détection de court-circuit et surcharge, si l'état de l'installation électrique est propice à la survenue d'un court-circuit ou d'une surcharge, par comparaison de cette valeur ou ces valeurs avec une ou des valeurs-seuils d'alarme correspondant à une détection de court-circuit, respectivement à une détection de surcharge.

Dans l'exemple considéré, le sous-module d'alarme 31 est en outre adapté pour déterminer, en fonction de la dernière valeur ou des dernières valeurs reçue(s) du paramètre (ou des paramètres) de détection de courant résiduel, si l'état de l'installation électrique est propice à la survenue d'un courant résiduel, par comparaison de cette valeur ou ces valeurs avec une ou des valeurs-seuils d'alarme correspondant à une détection de courant résiduel.

Lorsque le résultat de la comparaison effectuée indique que l'état de l'installation électrique 1 est propice à la survenue d'un dysfonctionnement relatif à une détection d'arc électrique, respectivement sous-tension, sur-tension, court-circuit, surcharge ou courant résiduel, une alarme est générée par le sous-module d'alarme 31 et est transmise à destination de l'interface homme-machine 13.

Cette alarme comprend, dans des modes de réalisation, un signalement sonore et/ou lumineux généré depuis le dispositif de contrôle et de protection électrique 10. Ce signalement sonore ou lumineux sera donc perçu par les personnes localisées à proximité du détecteur.

L'alarme peut comprendre à la place ou en outre, l'affichage sur un écran d'affichage de l'interface homme-machine 13, qui comme indiqué précédemment, est local au détecteur ou est situé à distance, et/ou la transmission par voie filaire ou radiofréquence, d'un message indiquant le dépassement du seuil d'alarme, l'identification du type de dysfonctionnement correspondant (détection d'arc, sous-tension, sur-tension, court-circuit, surcharge ou courant résiduel), et optionnellement la valeur du ou des paramètres de détection ayant donné lieu à l'alarme.

Ces dispositions permettent ainsi à l'utilisateur du dispositif de contrôle et de protection électrique de mener des opérations visant à régler le dysfonctionnement détecté, et ce avant qu'une coupure n'ait lieu.

Dans un mode de réalisation, les valeurs-seuils d'alarme et/ou les valeurs-seuils de déclenchement sont réglables à distance par un utilisateur du dispositif 10, via une liaison de communication filaire ou sans-fil, par exemple celle connectant le dispositif 10 à une partie distante de l'interface homme-machine 13.

Dans le cas d'un déclenchement du disjoncteur 14, un opérateur chargé de réaliser la maintenance du dispositif 10, doit identifier et éliminer le défaut avant de réenclencher le disjoncteur 14, pour ainsi permettre à nouveau la circulation du courant électrique dans l'installation 1.

Toutefois quand le disjoncteur 14 est déclenché, il est difficile de diagnostiquer quel est ce défaut.

Dans un mode de réalisation d'un dispositif selon l'invention, le module de traitement 12 comporte un sous-module de diagnostic 32. Le sous-module de déclenchement 30 est alors adapté pour, lorsqu'il a déterminé qu'un signal de déclenchement doit être généré suite au traitement de valeurs de paramètres fournis par l'un des sous-modules de détection 20-23, transmettre au sous-module de diagnostic 32, des données représentatives du dysfonctionnement détecté : type de dysfonctionnement détecté parmi une détection d'arc électrique, respectivement sous-tension, sur-tension, court-circuit, surcharge ou courant résiduel, et optionnellement la valeur des paramètres de détection correspondante.

Dans un mode de réalisation, le sous-module de diagnostic 32 est adapté pour traiter ces données pour éventuellement les compléter avec d'autres données fournies par les sous-modules de détection 20-23 ou par l'ensemble de mesure 11, et pour commander leur affichage sur un écran d'affichage de l'interface homme-machine 13, qui comme indiqué précédemment, est local au dispositif 10 ou est situé à distance, et/ou les transmettre dans un message via une liaison filaire ou radiofréquence à destination d'une partie distante de l'interface homme-machine 13 ou d'un service de maintenance tiers.

Dans un mode de réalisation, le sous-module de déclenchement 30 est adapté pour ne transmettre le signal de déclenchement à destination du disjoncteur 14 qu'après réception d'un message du sous-module de diagnostic 32 confirmant que le message de diagnostic a bien été envoyé et/ou affiché.

Dans un autre mode de réalisation, le sous-module de déclenchement 30 est conçu pour prendre en compte une temporisation donnée paramétrable, entre la transmission au sous-module de diagnostic 32, des données représentatives du dysfonctionnement détecté et la transmission le signal de déclenchement à destination du disjoncteur 14. Différer ainsi la transmission du signal de déclenchement permet de ne pas couper l'alimentation électrique du dispositif 10 avant que le signal de diagnostic ne soit transmis/affiché.

Dans un mode de réalisation, le dispositif de contrôle et de protection électrique 10 selon l'invention est adapté pour, lorsque l'alimentation électrique du détecteur 10 par le raccordement 15 est stoppée, mettre en œuvre l'alimentation électrique au moins du module de traitement 12 par les moyens auxiliaires 16 de fourniture d'alimentation électrique, ce qui permet là aussi d'assurer la communication des données de diagnostic même en cas de déclenchement.

Dans un tel cas, ces moyens auxiliaires 16 de fourniture d'alimentation électrique sont par exemple dimensionnés de manière à permettre le traitement par le sous-module de diagnostic des données transmises par le sous-module de déclenchement 30 correspondant au dysfonctionnement source de déclenchement.

Par exemple, le module de diagnostic 32 comprend un module de transmission de type Zigbee, qui ne consomme que pendant la phase de transmission, et les moyens auxiliaires 16 comprennent un condensateur adapté pour accumuler de l'énergie sur la base d'un courant faible provenant de l'alimentation principale par le raccordement 15 lorsque le disjoncteur n'est pas déclenché.

Lorsque l'alimentation principale par le raccordement 15 est stoppée suite à un déclenchement, les données de diagnostic sont envoyées par le module Zigbee à l'aide de l'énergie provenant de la décharge de ce condensateur.

Dans un mode de réalisation, la mémoire 21 comprend un journal d'historique mémorisant chacun des événements d'alarme, de déclenchement et/ou de diagnostic, ainsi que les données représentatives de l'événement (heure, type de dysfonctionnement ayant donné lieu à l'événement et optionnellement la valeur des paramètres de détection correspondante).

Dans un mode de réalisation, le module de traitement 12 comporte en outre un sous-module de supervision énergétique 24.

Le capteur 17 et ensemble de capteurs 18 sont adaptés pour mesurer régulièrement les valeurs de courant I et tension U au point de mesure du dispositif 10, et pour mesurer la consommation d'énergie dans le tableau électrique, correspondant à divers éléments respectifs de consommation d'énergie dans le circuit en aval du dispositif 10.

Les mesures effectuées en association avec pour chaque mesure, un identifiant du point de mesure à laquelle la mesure est relative, sont fournies au fur et à mesure au module de supervision énergétique 24.

Le module de supervision énergétique 24 est adapté pour déterminer, en fonction de ces mesures fournies, les valeurs efficaces de courant, de tension, les valeurs de puissances active et réactive, de facteur de puissance, d'énergie consommée relative à chaque élément associé à chacun des points de mesure respectifs.

Un tel module de supervision énergétique permet d'optimiser la gestion énergétique électrique en identifiant les principales sources de consommation effective d'énergie.

Les valeurs ainsi obtenues sont restituées sur un écran d'affichage de l'interface homme-machine 13, qui comme indiqué précédemment, est local au dispositif 10 ou est situé à distance, et/ou sont transmises dans un message via une liaison filaire ou radiofréquence à destination d'une partie distante de l'interface homme-machine 13 ou d'un service de maintenance tiers.

Dans un mode de réalisation, l'erreur de dispersion dans les mesures du capteur de tension 17 et/ou de courant 18 est corrigée, avant leur traitement décrit ci-dessus par le module de traitement 12, à l'aide d'une fonction de calibration en production par l'intermédiaire du microcalculateur 20. Par exemple, on peut programmer les valeurs spécifiques de gain et d'offset pour chaque capteur afin de compenser la dispersion liée à la construction du capteur.

Dans un mode de réalisation, l'ensemble de mesure 11 comporte en outre un capteur de température 19 adapté pour mesurer périodiquement la température ambiante au sein du détecteur 10.

La dérive en température dans les mesures du capteur de tension 17 et/ou de courant 18 est corrigée, avant leur traitement décrit ci-dessus par le module de traitement 12, à l'aide d'une fonction mettant en œuvre une courbe de compensation en température, sur la base de mesures de température au sein du détecteur 10 effectuées par le capteur de température 19.

Dans le mode de réalisation décrit en référence aux figures, une alimentation monophasée a été considérée. Bien sûr, l'invention est applicable relativement à tout type d'installation électrique avec une autre configuration en type et nombre de conducteur(s), par exemple une installation triphasée comportant 3 conducteurs de phase, et un conducteur de neutre.

Dans un mode de réalisation, les différentes valeurs-seuils sont dépendantes du réglage de courant nominal pour les détections de surcharge et de courts-circuits, et sont fixes pour la fonction de protection différentielle.

Ainsi l'invention permet, à partir d'un appareil de protection différentielle et/ou d'arc électrique existant, d'ajouter des fonctionnalités de protection ou de signalisation à cet appareil. Ces fonctionnalités supplémentaires utilisent des signaux d'entrée déjà présents dans l'appareil, sans perturber son fonctionnement. Ces fonctionnalités sont par exemple implémentées à l'aide d'un processeur dans un module de communication sans fil.

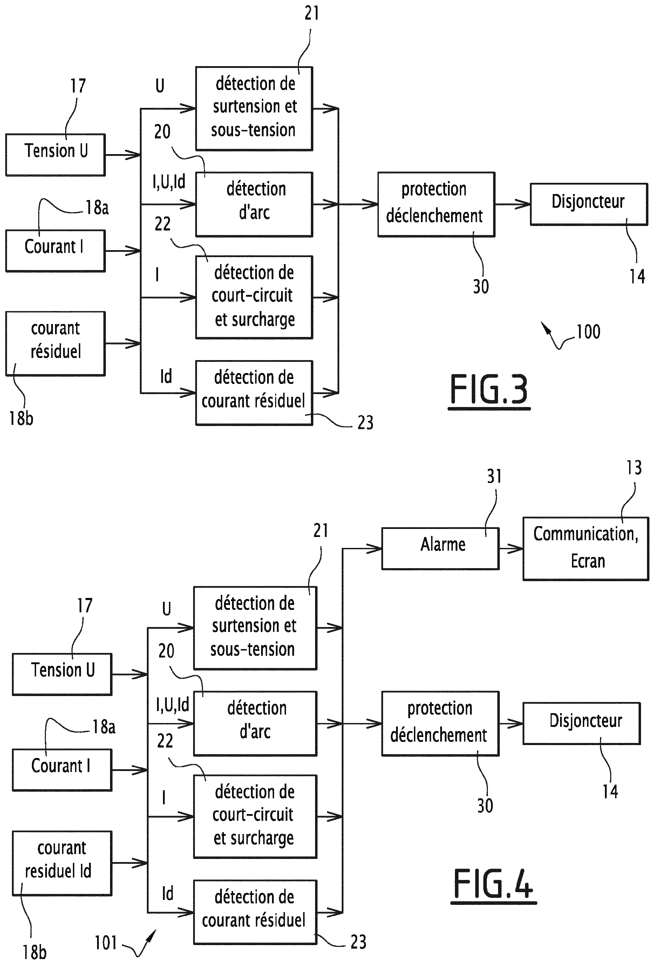

Dans des modes de réalisation de l'invention, seules une, certaines des fonctions ou toutes les fonctions du module de traitement 12 décrites ci-dessus sont implémentées dans un dispositif de contrôle et de protection électrique selon l'invention, comme illustré dans les figures 3 à 6.

Des références identiques entre les figures désignent des éléments similaires.

Le raccordement 15 à l'alimentation électrique principale n'a pas été représenté dans les figures 3-6.

A titre d'illustration, un dispositif de contrôle et de protection électrique 100 est représenté sur la figure 3 dans un mode de réalisation de l'invention. Il comporte un capteur de tension 17, un capteur de courant I 18a, un capteur de courant résiduel Id 18b et un sous-module de détection d'arc électrique 20 à partir des données U, I, Id.

Outre ces fonctionnalités d'un AFDD, le dispositif de contrôle et de protection électrique 100 comporte un sous-module de détection de sur-tension et sous-tension 21, un sous-module de détection de court-circuit et de surcharge 22 et un sous-module de détection de courant résiduel 23.

Il comporte en outre un sous-module de déclenchement 30 assurant la protection, contre les arcs électriques et en outre contre le court-circuit ; la surcharge, la protection différentielle et la protection contre la sur-tension et la sous-tension. Il comporte également un disjoncteur 14.

Toutefois, un déclenchement génère une coupure brutale et la continuité du service est interrompue.

En figure 4, un dispositif de contrôle et de protection électrique 101 est représenté, qui comporte en outre, par rapport au dispositif de contrôle et de protection électrique 100 de la figure 3, un sous-module d'alarme 31. Une alarme générée par ce sous-module est délivrée par l'IHM 13 (émission locale ou distante de son ou de signaux lumineux; transmission du signal d'alarme par un bus de communication à distance et affichage de l'alarme sur un écran de surveillance ...). L'émission d'une alarme avant l'ouverture du circuit électrique permet d'accroître la continuité du service, en informant l'utilisateur du dispositif de la survenue prochaine d'une coupure si la situation continue à se dégrader.

Toutefois, dans le cas d'un déclenchement lié à un défaut survenu dans l'installation à protéger, le service de maintenance doit d'abord chercher et éliminer le défaut avant de réenclencher le dispositif pour rétablir la tension. Mais lorsque le disjoncteur est déclenché, il est difficile de connaître le type de défaut.

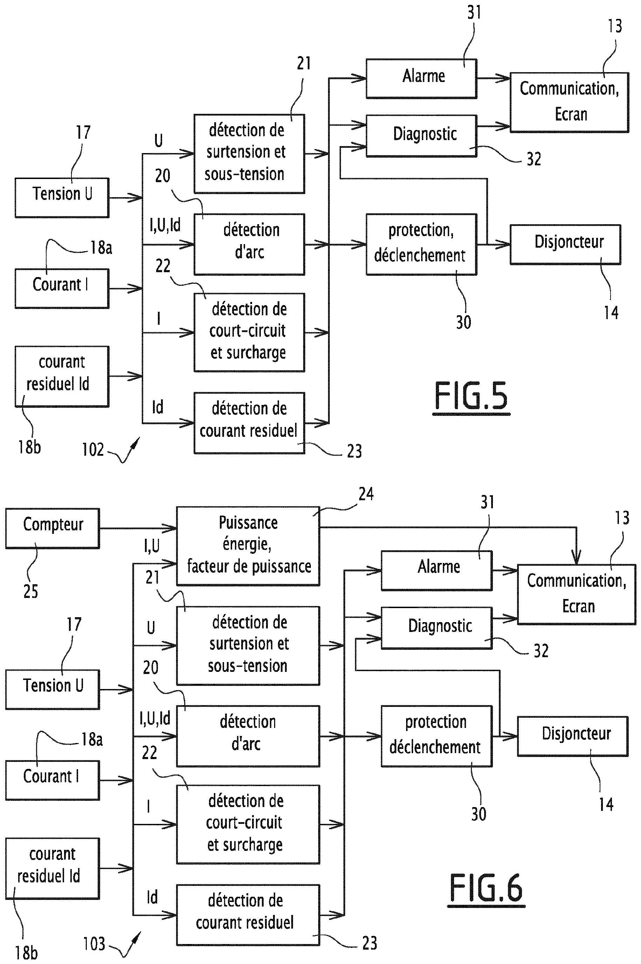

En vue de résoudre cet inconvénient, un dispositif de contrôle et de protection électrique 102, représenté en figure 5, est proposé. Il comporte en outre, par rapport au dispositif de contrôle et de protection électrique 101 de la figure 4, un sous-module de diagnostic 32. Les informations de diagnostic peuvent être affichées en face avant du dispositif ou transmises à distance via un bus de communication.

Afin d'optimiser la gestion énergétique électrique, un dispositif de contrôle et de protection électrique 103, représenté en figure 6, comporte en outre, par rapport au dispositif de contrôle et de protection électrique 102 de la figure 5, un sous-module de supervision énergétique 24. Un tel dispositif permet d'identifier les principales sources de consommation d'énergie en effectuant des mesures de puissance et d'énergie sur des points de mesure, à l'aide notamment d'un compteur de temps 25. Les informations de mesure peuvent être affichées en face avant du dispositif ou transmises à distance via un bus de communication.

## Revendications

1. Dispositif de contrôle et de protection électrique (10) adapté pour être disposé dans une installation électrique (1) comprenant un ensemble (2, 3) de conducteur(s) électrique(s), ledit dispositif comprenant :
- des moyens de mesure de la tension et/ou du courant (17, 18) dans au moins un conducteur dudit ensemble de conducteur ;
- un module de traitement (12), adapté pour détecter un arc électrique dans l'installation électrique en fonction au moins de mesures effectuées par lesdits moyens de mesure et pour générer, en cas de détection d'un arc électrique, un signal de déclenchement (TRIP) et transmettre ledit signal de déclenchement à destination d'un dispositif de commutation électrique (14) adapté pour stopper la circulation du courant électrique dans au moins ledit conducteur dudit ensemble de conducteurs électriques en réponse à la réception dudit signal de détection ;
ledit dispositif de contrôle et de protection électrique comprenant le module de traitement (12) adapté pour détecter en outre, en fonction au moins de certaines desdites mesures de la tension et/ou du courant dans le conducteur effectuées par lesdits moyens de mesure, au moins un dysfonctionnement parmi un court-circuit, une surcharge de courant électrique, une sur-tension, une sous-tension et un courant résiduel relatif à au moins ledit conducteur dudit ensemble de conducteurs électriques,
le module de traitement (12) étant en outre adapté pour générer, en cas de détection dudit dysfonctionnement, un signal de déclenchement (TRIP) et transmettre ledit signal de déclenchement à destination d'un dispositif de commutation électrique (14) adapté pour stopper la circulation du courant électrique dans au moins le conducteur dudit ensemble de conducteurs électriques (2, 3) en réponse à la réception dudit signal de détection,
le module de traitement (12) étant adapté pour, suite à la détection d'un dysfonctionnement, générer et pour transmettre un signal de diagnostic comprenant des informations caractérisant la nature du dysfonctionnement,
le dispositif de contrôle et de protection électrique (10) comprenant des moyens principaux (15) de fourniture d'énergie électrique en provenance de l'installation électrique (1) pour alimenter le module de traitement (12),
le dispositif de contrôle et de protection électrique étant **caractérisé en ce que** des moyens auxiliaires (16) de fourniture d'énergie électrique adaptés en outre pour stocker ladite énergie électrique, lesdits moyens auxiliaires de fourniture d'énergie électrique étant adaptés pour alimenter au moins le module de traitement (12) lorsque suite à la transmission d'un signal de déclenchement, l'alimentation électrique des moyens principaux par l'installation est stoppée, et
les moyens auxiliaires (16) de fourniture d'énergie électrique étant dimensionnés pour alimenter le module de traitement (12), au moins, suite à la transmission d'un signal de déclenchement par le module de traitement (12), et jusqu'à la transmission du signal de diagnostic.

2. Dispositif de contrôle et de protection électrique (10) selon la revendication 1, comprenant en outre un dispositif de commutation électrique (14) adapté pour stopper la circulation du courant électrique dans au moins ledit conducteur (2, 3) dudit ensemble de conducteurs électriques en réponse à la réception dudit signal de déclenchement généré par le module de traitement (12).

3. Dispositif de contrôle et de protection électrique (10) selon l'une des revendications précédentes, dans lequel le module de traitement (12) est adapté pour déterminer la valeur d'un paramètre en fonction au moins de mesures effectuées par lesdits moyens de mesure, et pour détecter un dysfonctionnement en fonction de la comparaison entre un seuil de déclenchement et une variable représentative de ladite valeur déterminée ;
ledit module de traitement (12) étant en outre adapté pour comparer ladite variable représentative de ladite valeur déterminée et un seuil d'alerte, distinct dudit seuil de déclenchement, et pour générer un signal d'alerte en fonction de ladite comparaison.

4. Dispositif de contrôle et de protection électrique (10) selon l'une des revendications précédentes, dans lequel le module de traitement (12) est adapté pour déterminer l'énergie consommée au point de mesure du dispositif 10 dans un tableau électrique, qui correspond à divers éléments respectifs de consommation d'énergie dans le circuit en aval du dispositif 10.

5. Dispositif de contrôle et de protection électrique (10) selon la revendication 4, dans lequel la détermination, par le module de traitement (12), de l'énergie consommée comprend le calcul de valeurs efficaces de courant et/ou de valeurs efficaces de tension, et/ou de la puissance active ou réactive, et/ou du facteur de puissance et/ou de l'énergie consommée.

6. Dispositif de contrôle et de protection électrique (10) selon l'une des revendications précédentes, comprenant un capteur de température (19), le module de traitement (12) étant adapté pour corriger les mesures de tension ou courant des moyens de mesure en fonction de température(s) mesurée(s) par le capteur de température.

## Patentansprüche

1. Elektrische Kontroll- und Schutzvorrichtung (10), die angepasst ist, um in einer elektrischen Installation (1) angeordnet zu sein, umfassend eine Einheit (2, 3) von elektrischen Leiter(n), die Vorrichtung umfassend:
- Messeinrichtungen der Spannung und/oder des Stroms (17, 18) in mindestens einem Leiter der Leitereinheit;
- ein Verarbeitungsmodul (12), das angepasst ist, um einen Lichtbogen in der elektrischen Installation abhängig zumindest von den Messungen, die durch Messeinrichtungen vorgenommen werden, zu erfassen, und um bei Erfassung eines Lichtbogens ein Auslösesignal (TRIP) zu erzeugen und das Auslösesignal an eine elektrische Schaltvorrichtung (14) zu übertragen, die angepasst ist, um den Fluss von elektrischem Strom in zumindest dem einen Leiter der Einheit von elektrischen Leitern als Reaktion auf den Empfang des Erfassungssignals zu unterbrechen;
die elektrische Überwachungs- und Schutzvorrichtung umfassend das Verarbeitungsmodul (12), das angepasst ist, um ferner abhängig von mindestens gewissen der Messungen der Spannung und/oder des Stroms in dem Leiter, die von den Messeinrichtungen vorgenommen werden, mindestens eine Störung von Kurzschluss, Überstrom, Überspannung, Unterspannung und Reststrom in Bezug auf mindestens den einen Leiter der Einheit von elektrischen Leitern zu erfassen,
wobei das Verarbeitungsmodul (12) ferner angepasst ist, um bei Erfassung der Störung ein Auslösesignal (TRIP) zu erzeugen und das Auslösesignal an eine elektrische Schaltvorrichtung (14) zu übertragen, die angepasst ist, um den Fluss des elektrischen Stroms in mindestens dem Leiter der Einheit von elektrischen Leitern (2, 3) als Reaktion auf den Empfang des Erfassungssignals zu unterbrechen,
wobei das Verarbeitungsmodul (12) angepasst ist, um nach dem Erfassen einer Störung ein Diagnosesignal zu erzeugen und zu übertragen, das Informationen umfasst, die die Art der Störung charakterisieren,
die elektrische Überwachungs- und Schutzvorrichtung (10) umfassend Haupteinrichtungen (15) zur Zuführung von elektrischer Energie aus der elektrischen Anlage (1), um das Verarbeitungsmodul (12) zu versorgen, wobei die elektrische Kontroll- und Schutzvorrichtung **dadurch gekennzeichnet ist, dass** Hilfseinrichtungen (16) zur Zuführung von elektrischer Energie ferner angepasst sind, um die elektrische Energie zu speichern, wobei die Hilfseinrichtungen zur Zuführung von elektrischer Energie angepasst sind, um zumindest das Verarbeitungsmodul (12) zu versorgen, wenn nach Übertragung eines Auslösesignals die Stromversorgung der Haupteinrichtungen durch die Installation gestoppt wird, und
wobei die Hilfseinrichtungen (16) zur Zuführung von elektrischer Energie bemessen sind, um das Verarbeitungsmodul (12) zumindest nach der Übertragung eines Auslösesignals durch das Verarbeitungsmodul (12) und bis zur Übertragung des Diagnosesignals zu versorgen.

2. Elektrische Kontroll- und Schutzvorrichtung (10) nach Anspruch 1, ferner umfassend eine elektrische Schaltvorrichtung (14), die angepasst ist, um den Fluss von elektrischem Strom in mindestens dem einen Leiter (2, 3) der Einheit von elektrischen Leitern als Reaktion auf den Empfang des von der Verarbeitungseinheit (12) erzeugten Auslösesignals zu unterbrechen.

3. Elektrische Kontroll- und Schutzvorrichtung (10) nach einem der vorherigen Ansprüche, wobei das Verarbeitungsmodul (12) angepasst ist, um den Wert eines Parameters abhängig mindestens von Messungen zu bestimmen, die durch die Messeinrichtungen vorgenommen werden, und eine Störung abhängig von dem Vergleich zwischen einem Auslöseschwellenwert und einer für den bestimmten Wert repräsentativen Variablen zu erfassen;
wobei das Verarbeitungsmodul (12) ferner angepasst ist, um die Variable, die repräsentativ für den bestimmten Wert ist, und einen Warnschwellenwert, der sich von dem Auslöseschwellenwert unterscheidet, zu vergleichen und um abhängig von diesem Vergleich ein Warnsignal zu erzeugen.

4. Elektrische Kontroll- und Schutzvorrichtung (10) nach einem der vorherigen Ansprüche, wobei das Verarbeitungsmodul (12) angepasst ist, um die an dem Messpunkt der Vorrichtung 10 in einer elektrischen Schalttafel verbrauchte Energie zu bestimmen, die verschiedenen jeweiligen Energieverbrauchselementen in der Schaltung stromabwärts von der Vorrichtung 10 entspricht.

5. Elektrische Kontroll- und Schutzvorrichtung (10) nach Anspruch 4, wobei die Bestimmung der verbrauchten Energie durch das Verarbeitungsmodul (12) die Berechnung von Effektivwerten des Stroms und/oder Effektivwerten der Spannung, und/oder der Wirk- oder Blindleistung, und/oder des Leistungsfaktors und/oder der verbrauchten Energie umfasst.

6. Elektrische Kontroll- und Schutzvorrichtung (10) nach einem der vorherigen Ansprüche, umfassend einen Temperatursensor (19), wobei das Verarbeitungsmodul (12) angepasst ist, um die Spannungs- oder Strommessungen der Messeinrichtungen abhängig von der/den von dem Temperatursensor gemessenen Temperatur(en) zu korrigieren.

## Claims

1. An electrical control and protection device (10) suitable for being positioned in an electrical installation (1) comprising a set (2, 3) of electrical conductor(s), said device comprising:
- means for measuring the voltage and/or current (17, 18) and at least one conductor of said conductor assembly;
- a processing module(12), suitable for detecting an electric arc in the electrical installation based at least on measurements done by said measuring means and, if an electric arc is detected, generating an activation signal (TRIP) and transmitting said activation signal to an electric switching device (14) suitable for stopping the flow of the electric current in at least said conductor of said set of electric conductors in response to the reception of said detection signal;
said electrical control and protection device comprising the processing module (12) suitable for further detecting, based at least on some of said voltage and/or current measurements in the conductor done by said measuring means, at least one malfunction from among a short circuit, an electric current overload, an overvoltage, an undervoltage and a residual current relative to at least said conductor of said set of electrical conductors,
the processing module (12) being further suitable for generating, if said malfunction is detected, an activation signal (TRIP) and transmitting said activation signal to an electric switching device (14) suitable for stopping the flow of the electric current in at least the conductor of said set of electric conductors (2, 3) in response to the reception of said detection signal,
the processing module (12) being suitable, following the detection of a malfunction, for generating and transmitting a diagnostic signal comprising information characterizing the nature of the malfunction,
the electrical control and protection device (10) comprising primary means (15) for supplying the electricity coming from the electrical installation (1) to power the processing module (12),
the electrical control and protection device (10) being **characterized in that** it comprises
secondary means (16) for supplying electricity further suitable for storing said electricity, said secondary electricity supply means being suitable for powering at least the processing module (12) when, following the transmission of an activation signal, the power supply of the primary means by the installation is stopped, and
the secondary electricity supply means (16) being sized to power the processing module (12), at least, following the transmission of an activation signal by the processing module (12), and until transmission of the diagnostic signal.

2. The electrical control and protection device (10) according to claim 1, wherein it further comprises an electric switching device (14) suitable for stopping the flow of electric current in at least said conductor (2, 3) of said set of electrical conductors in response to the reception of said activation signal generated by the processing module(12).

3. The electrical control and protection device (10) according to one of the preceding claims, wherein the processing module (12) is suitable for determining the value of a parameter based at least on measurements done by said measuring means, and detecting a malfunction based on the comparison between an activation threshold and a variable representative of said determined value;
said processing module (12) further being suitable for comparing said value representative of said determined value and an alert threshold, separate from said activation threshold, and generating an alert signal based on said comparison.

4. The electrical control and protection device (10) according to one of the preceding claims, wherein the processing module (12) is suitable for determining the energy consumed at the measuring point of the device 10 in an electrical panel, which corresponds to various respective energy-consuming elements in the circuit downstream from the device 10.

5. The electrical control and protection device (10) according to claim 4, wherein the determination, by the processing module (12), of the consumed energy comprises computing actual current values and/or actual voltage values, and/or the active or reactive power, and/or the power factor and/or the consumed energy.

6. The electrical control and protection device (10) according to one of the preceding claims, wherein it comprises a temperature sensor (19), the processing module (12) being suitable for correcting the voltage or current measurements of the measuring means based on temperature(s) measured by the temperature sensor.
